# EUROPEAN PATENT APPLICATION

(11) **EP 1 280 281 A1**
(43) Date of publication of application: **29.01.2003**
(21) Application number: 01915870.8
(22) Date of filing: 27.03.2001
(51) Int. Cl.: H03M 13/37

(54) **DECODER AND DECODING METHOD**

(30) Priority: 27.03.2000 JP 2000086831
(71) Applicant: MATSUSHITA ELECTRIC INDUSTRIAL CO., LTD., Kadoma-shi, Osaka 571-8501 (JP)
(72) Inventor: FUKUOKA, Toshihiko, Shijonawate-shi, Osaka 575-0061 (JP); SENDA, Hiroyuki, Kyotanabe-shi, Kyoto 610-0341 (JP)
(74) Representative: Grünecker, Kinkeldey, Stockmair & Schwanhäusser Anwaltssozietät
(86) International application number: JP0102522
(87) International publication number: WO01073952

(57) **Abstract**

Improper correction is avoided in decoding of an extended Reed-Solomon code. The decoding device includes: a syndrome computation section for computing input data syndromes from input data and corrected data syndromes from first corrected data obtained from the input data; an evaluator/locator polynomial deriving section for outputting coefficients at each order of an error evaluator polynomial and an error locator polynomial obtained based on the input data syndromes, as well as error magnitudes; a Chien search section for outputting roots of the error locator polynomial; and an error correction section for outputting data obtained by performing error correction for the input data when the input data has an error while otherwise outputting the input data, as the first corrected data, and also outputting the input data obtained by restoration when the first corrected data has an error while otherwise outputting the first corrected data, as second corrected data.

## Description

### TECHNICAL FIELD

The present invention relates to a decoding technology of performing multiple error correction for an extended Reed-Solomon code.

### BACKGROUND ART

Reed-Solomon codes have been extensively used as codes allowing multiple error correction in the occasions of storage of information in various mass-storage devices, transmission of information in high-speed communications and the like.

A Reed-Solomon code, which is one type of block error correcting code, is a code in a Galois field of which the primitive element is α when α is the root of W(z)=0 where W(z) is a primitive polynomial. Consider a Reed-Solomon code having roots in elements α⁰, α¹, ..., α^{^} (2^{m}-2) of a Galois field GF(2^{m}) of which the primitive element is α. This code has a code length n=2^{m}-1, and m bits constitute one processing unit, that is, one symbol. The amount of original information is n-2t symbols (t is the number of error corrections).

In general, the decoding of a Reed-Solomon code is carried out following the procedure of:
(a) computing syndromes,
(b) computing an error evaluator polynomial and an error locator polynomial,
(c) computing error locations by Chien search,
(d) computing error magnitudes, and
(e) correcting data based on the error locations and the error magnitudes. Details of this decoding method are disclosed in Japanese Laid-Open Patent Publication No.10-135846.

In recent years, in systems of cable modems, cable television and the like, specifications using an extended Reed-Solomon code for error correction have been adopted. An extended Reed-Solomon code is a code having a code length n equal to or more than the number of elements q of a Galois field from which roots of the code originate. The code is called a singly extended Reed-Solomon code when the code length n = q, and a doubly extended Reed-Solomon code when the code length n = q + 1.

For example, in a cable television system in North America, adopted is a singly extended Reed-Solomon code having the number of error corrections t=3, in which in a Galois field GF(2⁷), a primitive polynomial P(x) = x⁷ + x³ + 1 and a generator polynomial G_{L}(x) = (x+ α) (x+ α²) (x+ α³) (x+ α⁴) (x+ α⁵) are used. In this extended Reed-Solomon code, the generator polynomial G_{L}(x) is a fifth-order polynomial although the number of error corrections t = 3. This requires processing different from normal one during syndrome computation.

A normal Reed-Solomon code must be configured in a Galois field GF(2^{m+1}) having 2^{m+1} elements when it is intended to have a code length n of 2^{m}. However, an extended Reed-Solomon code is allowed to have a code length n of 2^{m} or more even when it is configured in a Galois field GF(2^{m}).

### -Problem to be solved-

Consider a Reed-Solomon code in a Galois field GF(2⁷) having the number of bits per symbol m=7 and the number of error corrections t=3.

If a normal Reed-Solomon code is considered, it has its roots in elements α⁰, α¹, ..., α¹²⁶ of the Galois field GF(2⁷) and a code length n=127. Since the order of a generator polynomial G(x) is double the number of error corrections t and the number of error corrections t = 3, the generator polynomial G(x) can be expressed as a sixth-order polynomial G(x) = (x+α) (x+ α²) (x+ α³) (x+ α⁴) (x+ α⁵) (x+ α⁶).

If an extended Reed-Solomon code is considered, it is possible to configure a code haying a larger code length in the same Galois field GF(2⁷) for error correction. For example, it is possible to consider an extended Reed-Solomon code having a code length n=128.

In decoding of a normal Reed-Solomon code, since the roots of an error locator polynomial have one-to-one correspondence with error locations. Therefore, the error locations are determined by solving the error locator polynomial by Chien search. The Chien search is a method in which all elements of a Galois field are sequentially substituted in an error locator polynomial and elements of which substitution makes the value of the polynomial zero are determined as roots of the error locator polynomial. For example, when the number of error corrections t = 3, the elements are sequentially substituted in a third-order error locator polynomial, and elements of which substitution makes the value of the polynomial zero are determined as three roots of the error location polynomial.

If errors exceeding the correction ability are added to a codeword, an error evaluator polynomial and an error locator polynomial fail to be derived correctly or roots of the error locator polynomial fail to be derived correctly by Chien search. By these failures, inability of error correction is recognized. In this event, input data is output as it is without execution of error correction.

However, in an extended Reed-Solomon code, since the code length n is larger than the number of elements of the Galois field GF(2⁷) other than 0, no one-to-one correspondence is established between the elements and the error locations. Therefore, in the Chien search, processing different from that in decoding of a normal Reed-Solomon code must be performed.

In view of the above, an extended Reed-Solomon code is decoded under the following presumption. An extended Reed-Solomon code having a code length n=128, for example, is composed of 122 information symbols and 6 redundant symbols when the number of error corrections is 3. In the Galois field GF(2⁷), only 127 symbols can be corrected by Chien search. Therefore, only 127 symbols among the 128 symbols of the received word excluding one redundancy symbol are subjected to error correction.

However, the above method has a problem that improper correction may occur because 127 symbols of a code composed of 128 symbols are corrected by using the code and an error may be generated for the one redundant symbol that is not subjected to correction.

### DISCLOSURE OF THE INVENTION

An object of the present invention is providing a decoding device and a decoding method in which whether or not error correction is possible for a received word of an extended Reed-Solomon code is decided during decoding of the word, and properly corrected data is obtained when error correction is possible while improper correction is avoided when error correction is not possible.

The decoding device in the first aspect of the invention includes a correction processing section for performing error correction for a received word made of an extended Reed-Solomon code to determine corrected data, wherein the correction processing section decides whether or not the generated corrected data has an error based on syndromes of the corrected data, and the correction processing section outputs the corrected data when errorless corrected data is generated, while outputting the received word before the error correction when errorless corrected data fails to be generated.

According to the decoding device described above, when failure to generate errorless corrected data is finally decided, output of the non-properly corrected data is avoided.

In the decoding device described above, the correction processing section preferably decides that errorless corrected data fails to be generated when the corrected data generated from the received word has an error.

With the above configuration, when the corrected data has an error, failure to generate errorless corrected data is determined without further execution of error correction, and the received word before the error correction is output.

In the decoding device described above, preferably, the correction processing section executes the error correction repeatedly until errorless corrected data is generated, and decides that errorless corrected data fails to be generated when no errorless corrected data is generated after execution of the error correction a plurality of times.

With the above configuration, the possibility of generating errorless corrected data increases by the repeated error correction.

The decoding device in the second aspect of the present invention includes: a syndrome computation section for receiving a received word made of an extended Reed-Solomon code as input data, computing syndromes for the input data as input data syndromes, and outputting a first flag signal indicating whether or not the input data has an error that is determined based on the input data syndromes, while computing syndromes for first corrected data obtained based on the input data as corrected data syndromes and outputting a second flag signal indicating whether or not the first corrected data has an error that is determined based on the corrected data syndromes; an evaluator/locator polynomial deriving section for computing coefficients at each order of an error evaluator polynomial and an error locator polynomial based on the input data syndromes, and computing error magnitudes based on error evaluation values and corresponding error locator polynomial differential values both obtained from the coefficients; a Chien search section for determining roots of the error locator polynomial based on the coefficients, and computing the error evaluation values by substituting the roots in the error evaluator polynomial and the error locator polynomial differential values by substituting the roots in a derivative of the error locator polynomial; and an error correction section for outputting data obtained by performing the error correction for the input data based on the roots and the corresponding error magnitudes as the first corrected data when the first flag signal indicates that the input data has an error, while outputting the input data as the first corrected data when the first flag signal indicates that the input data has no error, the error correction section outputting data obtained by performing restoration for the first corrected data to restore the data before the error correction as second corrected data when the second flag signal indicates that the first corrected data has an error, while outputting the first corrected data as the second corrected data when the second flag signal indicates that the first corrected data has no error.

According to the decoding device described above, not only the input data syndromes but also the corrected data syndromes are obtained. This makes it possible to determine whether or not the error correction has been executed properly.

In the decoding device described above, preferably, the syndrome computation section includes: a selector for receiving and alternately outputting the input data and the first corrected data output from the error correction section; a syndrome operator for computing the input data syndromes and the corrected data syndromes based on the input data and the first corrected data output from the selector; an input data syndrome holder for holding and outputting the input data syndromes; a corrected data syndrome holder for holding and outputting the corrected data syndromes; a first zero syndrome detector for outputting the first flag signal indicating that the input data has no error when all the input data syndromes output from the input data syndrome holder are zero and otherwise indicating that the input data has an error; and a second zero syndrome detector for outputting the second flag signal indicating that the first corrected data has no error when all the corrected data syndromes output from the corrected data syndrome holder are zero and otherwise indicating that the first corrected data has an error.

With the above configuration, the input data syndromes and the corrected data syndromes are obtained in parallel, and the first and second flag signals are output simultaneously. Therefore, whether or not the input data and the first corrected data have an error can be determined simultaneously.

In the decoding device described above, preferably, the evaluator/locator polynomial deriving section determines coefficients at each order of the error evaluator polynomial and the error locator polynomial based on the input data syndromes by Euclidean algorithm operation and outputs the computed coefficients, and the evaluator/locator polynomial deriving section outputs the coefficients even when the order of the error locator polynomial is equal to or less than the order of the error evaluator polynomial at the completion of the Euclidean algorithm operation.

With the above configuration, the error evaluator polynomial and the error locator polynomial can be obtained irrespective of the results of the Euclidean algorithm operation. Therefore, the error locations and the error magnitudes can be determined for decoding of the extended Reed-Solomon code.

In the decoding device described above, preferably, the Chien research section sequentially substitutes elements of a Galois field in which roots of the extended Reed-Solomon code are defined in the error locator polynomial to determine elements of which substitution makes the value of the error locator polynomial zero as the roots of the error locator polynomial, and the Chien research section outputs the roots of the error locator polynomial even when the number of different roots of the error locator polynomial is less than the order of the error locator polynomial.

With the above configuration, the different roots of the error locator polynomial obtained by Chien search can be used irrespective of the number of the roots. Therefore, the error locations and the error magnitudes can be determined for decoding of the extended Reed-Solomon code.

In the decoding device described above, preferably, the error correction section includes: a first error corrector for outputting data obtained by performing the error correction for the input data when the first flag signal indicates that the input data has an error, the error correction including subtracting the corresponding error magnitude from a symbol indicated by the error location corresponding to each of the roots, while otherwise outputting the input data as the first corrected data; an error location data holder for holding and outputting the error locations; an error magnitude data holder for holding and outputting the error magnitudes; and a second error corrector for outputting data obtained by performing the restoration for the first corrected data to restore the data before the error correction when the second flag signal indicates that the first corrected data has an error, the restoration including adding the corresponding error magnitude to a symbol indicated by the error location, while otherwise outputting the first corrected data as the second corrected data.

With the above configuration, the correction of the input data and the restoration for the first corrected data can be performed in parallel. Therefore, high-speed processing is possible.

Preferably, the decoding device described above further includes a data storage section for holding the input data until the error correction section starts determining the first corrected data and then outputting the input data, and holding the first corrected data until the error correction section starts determining the second corrected data and then outputting the first corrected data.

With the above configuration, data required for the error correction section can be supplied at appropriate timings. In addition, it is only necessary to store either the input data or the first corrected data generated from the input data for one received word. Therefore, the capacity of the data storage section can be reduced.

The decoding method in the third aspect of the invention includes a correction processing step of performing error correction for a received word made of an extended Reed-Solomon code to determine corrected data, wherein the correction processing step includes deciding whether or not the generated corrected data has an error based on syndromes of the corrected data, and when errorless corrected data is generated, the generated corrected data is determined as the corrected data to be obtained, while when errorless corrected data fails to be generated, the received word before the error correction is determined as the corrected data to be obtained.

In the decoding method described above, preferably, in the correction processing step, failure of generation of errorless corrected data is decided when the corrected data generated from the received word has an error.

In the decoding method described above, preferably, in the correction processing step, the error correction is executed repeatedly until errorless corrected data is generated, and failure of generation of errorless corrected data is decided when no errorless corrected data is generated after execution of the error correction a plurality of times.

### - Effect of the Invention-

According to the decoding device and the decoding method of the present invention, error-corrected data is subjected to syndrome computation again for error detection. Therefore, improper correction can be prevented, and thus decoding of not only a normal Reed-Solomon code but also an extended Reed-Solomon code can be realized.

### BRIEF DESCRIPTION OF THE DRAWINGS

FIG. **1** is a block diagram of a Reed-Solomon decoding device of an embodiment of the present invention.
FIG. **2** is a flowchart of processing performed by the Reed-Solomon decoding device of FIG. **1**.
FIG. **3** is a block diagram of a syndrome computation section in FIG. **1**.
FIG. **4** is a block diagram of an error correction section in FIG. **1**.
FIG. **5** is a timing chart illustrating operation of the Reed-Solomon decoding device of FIG. **1**.
FIG. **6** is a timing chart illustrating internal operation of the syndrome computation section of FIG. **3**.

### BEST MODE FOR CARRYING OUT THE INVENTION

Hereinafter, a preferred embodiment of the present invention will be described with reference to the accompanying drawings.

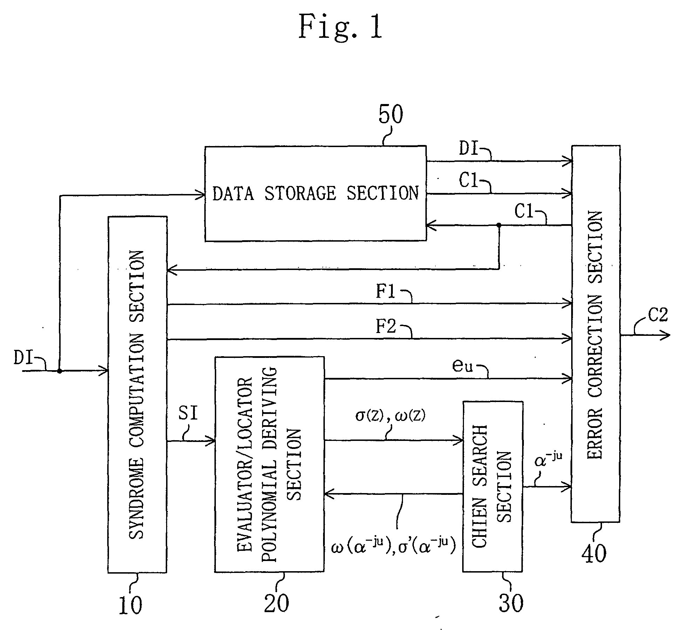

FIG. **1** is a block diagram of a Reed-Solomon decoding device of an embodiment of the present invention. The Reed-Solomon decoding device of FIG. **1** includes a syndrome computation section **10,** an evaluator/locator polynomial deriving section **20,** a Chien search section **30,** an error correction section **40** and a data storage section **50.** The syndrome computation section **10,** the evaluator/locator polynomial deriving section **20,** the Chien search section **30** and the error correction section **40** constitute a correction processing section.

The Reed-Solomon decoding device of FIG. **1** receives a word composed of an extended Reed-Solomon code as input data **DI,** decodes the input data **DI,** and outputs the resultant data as second corrected data **C2.** Hereinafter, assume as an example that the input extended Reed-Solomon code is a singly extended Reed-Solomon code in a Galois field GF(2⁷) in which the number of bits per symbol m = 7 and the code length n = 128. One received word is composed of 128 symbols. Assume also that the number of error corrections t = 3. This extended Reed-Solomon code therefore allows error correction of 3 symbols.

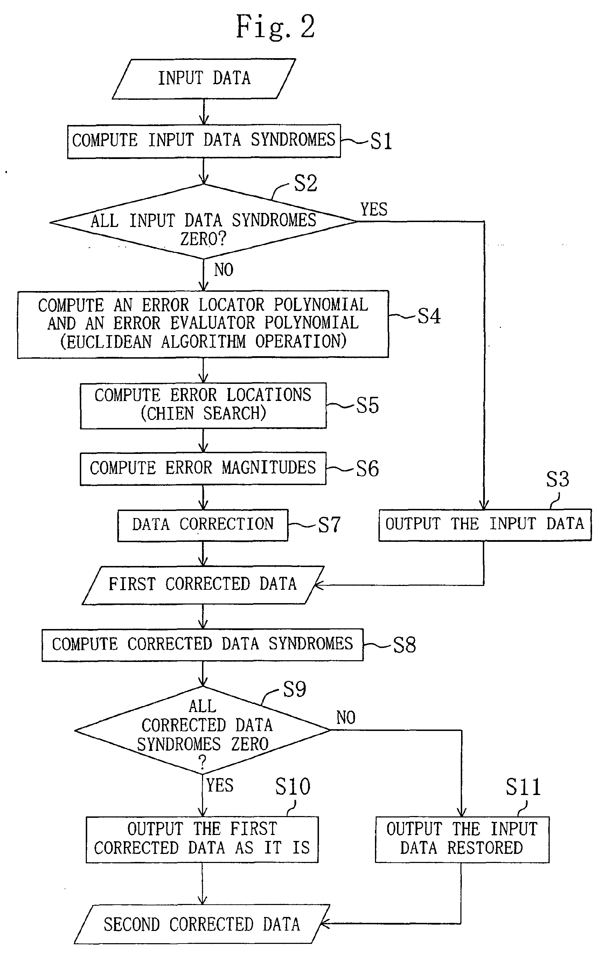

FIG. **2** is a flowchart of processing performed by the Reed-Solomon decoding device of FIG. **1.** Hereinafter, the processing will be described with reference to FIG. **1** and steps **S1** to **S11** in FIG. **2**. Assume that an error having a magnitude of eᵤ has occurred in the symbol at a location ju in the received word, where u = 1, 2, ..., k (k ≦ t). The location ju of the symbol having an error in a received word is herein called the error location.

Input data **DI** is input into the syndrome computation section **10** and the data storage section **50.** The data storage section **50** stores the input data **DI** and then outputs the data to the error correction section **40.**

In step **S1,** the syndrome computation section **10** computes syndromes of the input data **DI** as input data syndromes **SI.**

In step **S2,** the syndrome computation section **10** detects whether or not all the input data syndromes **SI** are zero. If all the input data syndromes **SI** are zero, the syndrome computation section **10** decides that the input data **DI** has no error, and asserts a first non-error state indication signal **F1** as a first flag signal that is output to the error correction section **40.** The process then proceeds to step **S3.** If there is a non-zero input data syndromes **SI,** the syndrome computation section **10** decides that the input data **DI** has an error, and negates the first non-error state indication signal **F1** that is output to the error correction section **40.** In this case, the process proceeds to step **S4.** In either case, the syndrome computation section **10** outputs the input data syndromes **SI** to the evaluator/locator polynomial deriving section **20.**

In step **S3**, receiving the asserted first non-error state indication signal **F1** indicating that no error correction is necessary, the data correction section **40** outputs the input data **DI** received from the data storage section **50** to the syndrome computation section **10** and the data storage section **50** as it is as first corrected data **C1**.

Processing in steps **S4** through **S7** is performed when the first non-error state indication signal **F1** is negated indicating that the input data **DI** has an error.

In step **S4,** the evaluator/locator polynomial deriving section **20** computes coefficients at each order of an error locator polynomial σ (z) and an error evaluator polynomial ω (z) from the input data syndromes **SI** by Euclidean algorithm operation, and outputs the resultant coefficients of the polynomials to the Chien search section **30.**

The evaluator/locator polynomial deriving section **20** includes a data holder (not shown) and a Galois operator (not shown). The data holder holds the input data syndromes **SI** and intermediate results of Euclidean algorithm operation, and finally outputs the coefficients at each order of the error locator polynomial σ (z) and the error evaluator polynomial ω(z). The Galois operator executes Euclidean algorithm operation for the output from the data holder to obtain the intermediate results and sends the intermediate results to the data holder. Details of the Euclidean algorithm operation are disclosed in Japanese Laid-Open Patent Publication No. 10-135846.

Note that the evaluator/locator polynomial deriving section **20** in FIG. **1** outputs the coefficients of the polynomials even when the order of the error locator polynomial σ (z) is equal to or less than the order of the error evaluator polynomial ω(z) at the completion of the Euclidean algorithm operation.

In step **S5,** the Chien search section **30** performs Chien search to determine roots α^{-ju} of the error locator polynomial σ(z). More specifically, the Chien search section **30** sequentially substitutes the elements of the Galois field GF(2⁷) in the error locator polynomial σ(z), determines the elements of which substitution makes the value of the error locator polynomial σ(z) zero as the roots α^{-ju} of the error locator polynomial σ(z), and outputs the roots to the error correction section **40.** During this operation, the Chien search section **30** does not make decision on whether or not error correction is possible even when the number of different roots of the error locator polynomial σ (z) in the Galois field GF(2⁷) is less than the order of the error locator polynomial σ (z), and outputs the roots α^{-ju} to the error correction section **40.** The error locations ju correspond to the respective roots α^{-ju} of the error locator polynomial σ (z).

In addition, the Chien search section **30** substitutes the respective roots α^{-ju} of the error locator polynomial σ(z) in the error evaluator polynomial ω(z) to obtain respective error evaluation values ω(α^{-ju}), and also substitutes the respective roots α^{-ju} of the error locator polynomial σ (z) in a derivative of the error locator polynomial σ(z) to obtain error locator polynomial differential values σ'(α^{-ju}). The Chien search section **30** outputs the error evaluation values ω(α^{-ju}) and the error locator polynomial differential values σ'(α^{-ju}) to the evaluator/locator polynomial deriving section 20.

In step **S6,** the Galois operator (not shown) of the evaluator/locator polynomial deriving section **20** divides each of the error evaluation values ω( α^{-ju}) by the corresponding error locator polynomial differential value σ '(α^{-ju}) to obtain an error magnitude eᵤ indicating the error bit in the symbol at the error location ju, and outputs the results to the error correction section **40.**

In step **S7,** the error correction section **40** performs error correction for the input data **DI** received from the data storage section **50** based on the error locations ju corresponding to the roots α^{-ju} of the error locator polynomial σ (z) output from the Chien search section **30** and the error magnitudes eᵤ output from the evaluator/locator polynomial deriving section **20.** More specifically, the corresponding error magnitude eᵤ is subtracted from the symbol at the error location ju in the received word as the input data **DI.** Since this is an operation in the extension field of the Galois field GF(2), addition of the error magnitude eᵤ to the symbol is allowed in place of the subtraction.

The error correction section **40** outputs error-corrected data to the syndrome computation section **10** and the data storage section **50** as the first corrected data **C1**. The data storage section **50** stores the first corrected data **C1** and outputs this again to the error correction section **40.**

In step **S8,** the syndrome computation section **10** computes syndromes of the first corrected data **C1** as corrected data syndromes **SC.**

In step **S9,** the syndrome computation section **10** detects whether or not all the corrected data syndromes **SC** are zero. If all the corrected data syndromes **SC** are zero, the syndrome computation section **10** decides that the first corrected data **C1** has no error, and asserts a second non-error state indication signal **F2** as a second flag signal that is output to the error correction section **40.** The process then proceeds to step **S10**. If there is a non-zero corrected data syndromes **SC,** the syndrome computation section **10** decides that the first corrected data **C1** has an error, and negates the second non-error state indication signal **F2** that is output to the error correction section **40.** In this case, the process proceeds to step **S11.**

In step **S10,** receiving the asserted second non-error state indication signal **F2** indicating that the first corrected data **C1** has no error, the data correction section **40** outputs the first corrected data **C1** received from the data storage section **50** as it is as the second corrected data **C2.**

In step **S11**, receiving the negated second non-error state indication signal **F2** indicating that the first corrected data **C1** has an error, the data correction section **40** restores the input data **DI** before the correction from the first corrected data **C1** received from the data storage section **50** based on the error locations ju corresponding to the roots α^{-ju} of the error locator polynomial σ (z) output from the Chien search section **30** and the error magnitudes eᵤ output from the evaluator/locator polynomial deriving section **20.** More specifically, the corresponding error magnitude eᵤ is added to or subtracted from the symbol at the error location ju in the first corrected data **C1.** The error correction section **40** outputs the restored input data **DI** as the second corrected data **C2.**

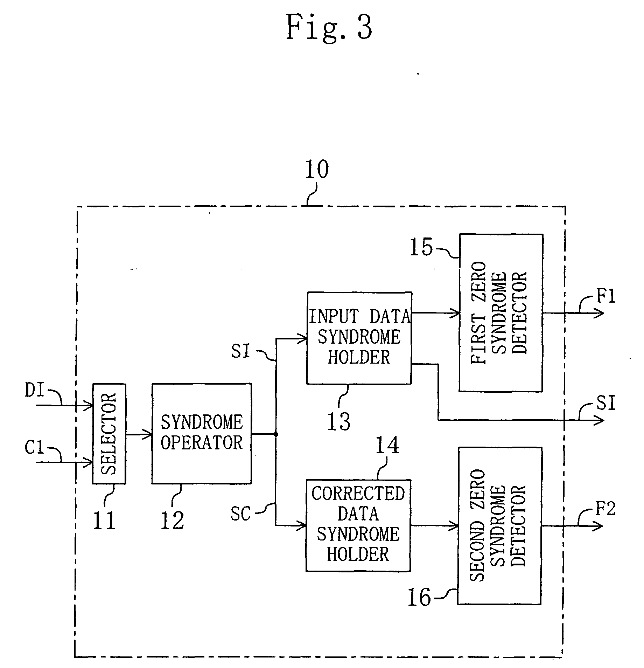

FIG. **3** is a block diagram of the syndrome computation section **10** in FIG. **1.** Referring to FIG. **3,** the syndrome computation section **10** includes a selector **11,** a syndrome operator **12,** an input data syndrome holder **13,** a corrected data syndrome holder **14,** a first zero syndrome detector **15** and a second zero syndrome detector **16.**

The selector **11** receives the input data **DI** and the first corrected data **C1** and outputs both the data to the syndrome operator **12** alternately. The syndrome operator **12,** operating in synchronization with the selector **11,** performs computation for obtaining the input data syndromes **SI** and computation for obtaining the corrected data syndromes **SC** alternately, and outputs the computation results to the input data syndrome holder **13** and the corrected data syndrome holder **14,** respectively.

The input data syndrome holder **13** receives and holds only the input data syndromes **SI** from the output of the syndrome operator **12,** and then outputs the input data syndromes **SI** to the first zero syndrome detector **15.** When all the input data syndromes **SI** are zero, the first zero syndrome detector **15** decides that the input data **DI** has no error and asserts the first non-error state indication signal **F1.** When there is a non-zero input data syndromes **SI,** the first zero syndrome detector **15** decides that the input data **DI** has an error and negates the first non-error state indication signal **F1.** The signal **F1** is output to the error correction section **40.** In addition, the input data syndrome holder **13** outputs the input data syndromes **SI** to the evaluator/locator polynomial deriving section 20 in synchronization with the timing at which the first zero syndrome detector **15** sends the first non-error state indication signal **F1.**

Likewise, the corrected data syndrome holder **14** receives and holds only the corrected data syndromes **SC** from the output of the syndrome operator **12,** and then outputs the corrected data syndromes **SC** to the second zero syndrome detector **16.** The second zero syndrome detector **16** asserts the second non-error state indication signal **F2** when all the corrected data syndromes **SC** are zero, and negates the second non-error state indication signal **F2** when there is a non-zero corrected data syndrome **SC**. The signal **F2** is output to the error correction section **40.**

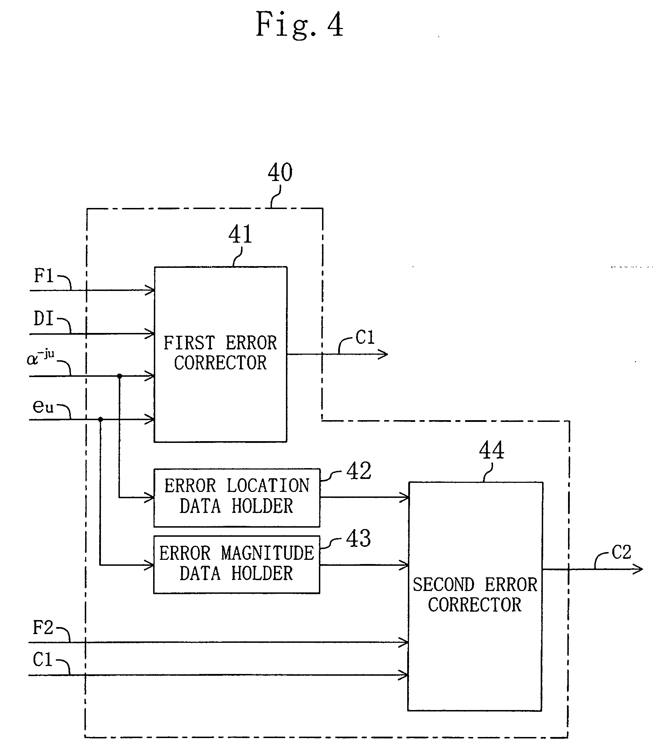

FIG. **4** is a block diagram of an error correction section **40** in FIG. **1.** Referring to FIG. **4,** the error correction section **40** includes a first error corrector **41,** an error location data holder **42,** an error magnitude data holder **43** and a second error corrector **44.**

The first error corrector **41** receives the first non-error state indication signal **F1,** the input data **DI** output from the data storage section **50,** the roots α^{-ju} of the error locator polynomial σ (z) output from the Chien search section **30** and the error magnitudes eᵤ output from the evaluator/locator polynomial deriving section **20.**

The first error corrector **41** outputs the input data **DI** as it is as the first corrected data **C1** when the first non-error state indication signal **F1** is active requiring no error correction for the input data **DI.** When the first non-error state indication signal **F1** is inactive, indicating that the input data **DI** has an error and error correction is necessary, the first error corrector **41** performs error correction for the input data **DI.** Specifically, the error magnitudes eᵤ corresponding to the error locations ju, which correspond to the roots α^{-ju}, are subtracted from or added to the symbols of the input data **DI** indicated by the error locations ju. The first error corrector **41** outputs the corrected data as the first corrected data **C1** to the syndrome computation section **10** and the data storage section **50.**

The error location data holder **42** stores the roots α^{-ju} and outputs them to the second error corrector **44.** The error magnitude data holder **43** stores the error magnitudes eᵤ and outputs them to the second error corrector **44.**

The second error corrector **44** receives the second non-error state indication signal **F2,** the first corrected data **C1** output from the data storage section **50,** the roots α^{-ju} of the error locator polynomial σ (z) and the error magnitudes eᵤ.

The second error corrector **44** outputs the first corrected data **C1** as it is as the second corrected data **C2** when the second non-error state indication signal **F2** is active requiring no error correction for the first corrected data **C1.** When the second non-error state indication signal **F2** is inactive, indicating that the first corrected data **C1** has an error and error correction is necessary, the second error corrector **44** performs restoration of the input data **DI** before the correction by the first error corrector **41** from the first corrected data **C1** based on the error locations ju corresponding to the roots α^{-ju} and the error magnitudes eᵤ. This can be done by adding or subtracting the error magnitudes eᵤ corresponding to the error locations ju to or from the symbols of the first corrected data **C1** indicated by the error locations ju. The second error corrector **44** outputs the restored input data **DI** as the second corrected data **C2.**

As described above, the second error corrector **44** outputs the restored input data **DI,** not the first corrected data **C1,** when the first error corrector **41** fails to correct the input data **DI** properly resulting in the first corrected data **C1** having an error.

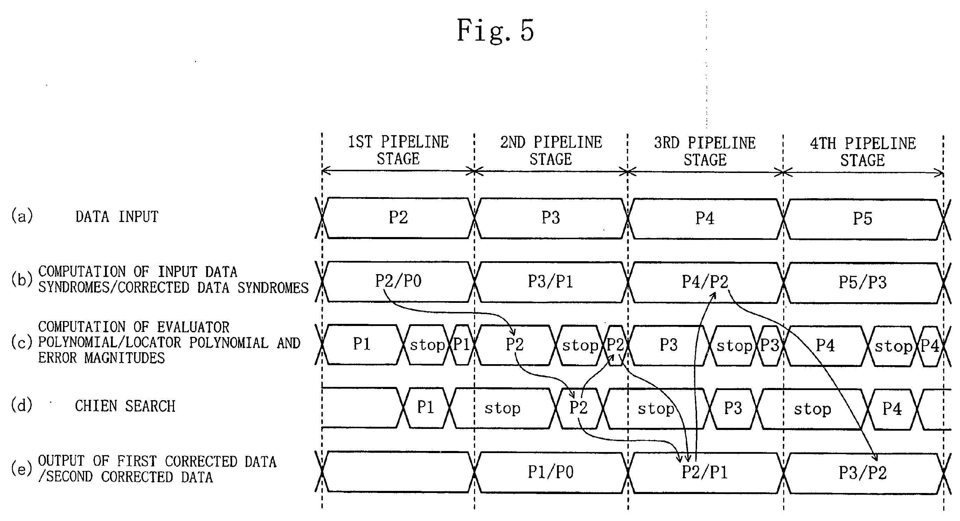

FIG. **5** is a timing chart illustrating operation of the Reed-Solomon decoding device of FIG. **1.** In FIG. **5, (a)** represents input of the input data **DI** into the syndrome computation section **10** and the data storage section **50, (b)** represents computation of the input data syndromes **SI** and the corrected data syndromes **SC** by the syndrome computation section **10, (c)** represents computation of the error evaluator polynomial ω(z), the error locator polynomial σ(z) and the error magnitudes eᵤ by the evaluator/locator polynomial deriving section **20, (d)** represents Chien search by the Chien search section **30,** and **(e)** represents output of the first and second corrected data **C1** and **C2** from the error correction section **40.**

In FIG. **5, P0** to **P5** indicate that tasks related to packets input 0-th to fifth, respectively, are being executed, and **stop** indicates that the operation is at a stop. One received word having a code length n=128 is handled as one packet. Hereinafter, the operation is described focusing on packet **P2,** in particular.

In the first pipeline stage, packet **P2** is input into the syndrome computation section **10** and the data storage section **50** as the input data **DI.** The syndrome computation section **10** computes the input data syndromes **SI** for packet **P2** (**(a)** and **(b)** in FIG. **5**).

In the second pipeline stage, the evaluator/locator polynomial deriving section **20** computes coefficients at each order of the error locator polynomial σ (z) and the error evaluator polynomial ω (z) using the input data syndromes **SI** for packet **P2** computed in the first pipeline stage (**(c)** in FIG. **5**). Thereafter, using the error locator polynomial σ**(z)** and the error evaluator polynomial ω(z), the Chien search section **30** computes the roots α^{-ju} of the error locator polynomial σ(z), the error evaluation values ω(α^{-ju}) and the error locator polynomial differential values σ'(α^{-ju}) for packet **P2** by Chien search (**(d)** in FIG. 5). Using the error evaluation values ω(α^{-ju}) and the error locator polynomial differential values σ'(α^{-ju}) for packet **P2,** the evaluator/locator polynomial deriving section **20** computes the error magnitudes eᵤ (**(c)** in FIG. **5**). In the second pipeline stage, one of the evaluator/locator polynomial deriving section **20** and the Chien search section **30** is at rest when the other is under operation.

To enable the above processing, the evaluator/locator polynomial deriving section **20** and the Chien search section **30** receive a clock signal (not shown) having a frequency four times as high as that of a reference clock signal (not shown).

In the third pipeline stage, the error correction section **40** performs error correction for packet **P2** as the input data **DI** held by the data storage section **50,** if necessary, using the roots α^{-ju} of the error locator polynomial σ(z) and the error magnitudes eᵤ for packet **P2** computed in the second pipeline stage, to obtain the first corrected data **C1** (**(e)** in FIG. **5**). The error correction section **40** outputs the first corrected data **C1** to the syndrome computation section **10** and the data storage section **50.** In the third pipeline stage, also, the syndrome computation section **10** computes the corrected data syndromes **SC** based on the first corrected data **C1** for packet **P2**. This stage also includes input of packet **P4** into the syndrome computation section **10** and the data storage section **50.** Therefore, the syndrome computation section **10** also computes the input data syndromes **SI** for packet **P4** (**(b)** in FIG. **5**).

For the parallel computation of the input data syndromes **SI** and the corrected data syndromes **SC,** the syndrome computation section **10** receives a clock signal (not shown) having a frequency twice as high as that of the reference clock signal (not shown).

In the fourth pipeline stage, when some of the corrected data syndromes **SC** of the first corrected data **C1** for packet **P2** is not zero, the error correction section **40** outputs the input data **DI** before the correction as the second corrected data **C2** by restoring the input data **DI** from the first corrected data **C1** held by the data storage section **50.** When all the corrected data syndromes **SC** are zero, the error correction section **40** outputs the first corrected data **C1** held by the data storage section **50** as it is as the second corrected data **C2.** In this stage, the error correction section **40** also performs error correction for packet **P3,** which has been input into the syndrome computation section **10** in the second pipeline stage, to obtain the first corrected data **C1** for this packet (**(e)** in FIG. **5**).

A series of processing for packet **P2** is completed by the four pipeline stages described above. Note that the error correction section **40** and the data storage section **50** receive the reference clock signal (not shown).

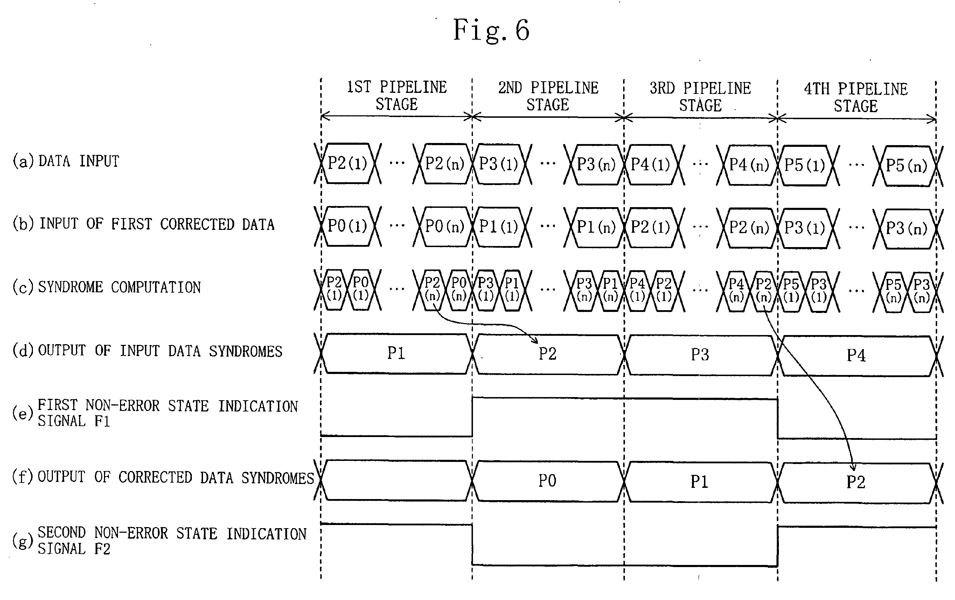

FIG. **6** is a timing chart illustrating internal operation of the syndrome computation section **10** of FIG. **3**. In FIG. **6**, **(a)** represents input of the input data **DI** into the selector **11, (b)** represents input of the first corrected data **C1** into the selector **11, (c)** represents syndrome computation by the syndrome operator **12, (d)** represents output of the input data syndromes **SI** from the input data syndrome holder **13, (e)** represents output of the first non-error state indication signal **F1** from the first zero syndrome detector **15, (f)** represents output of the corrected data syndromes **SC** from the corrected data syndrome holder **14,** and **(g)** represents output of the second non-error state indication signal **F2** from the second zero syndrome detector **16.** In FIG. **6,** as in FIG. **5, P0** to **P5** indicate that tasks related to packets input 0-th to fifth, respectively, are being executed, and **P(n)** indicates that a task related to the n-th symbol of packet **P2** is being executed.

In the first pipeline stage, symbols P2(1), P2(2), ..., P2(n) of packet **P2** as the input data **DI** are sequentially input into the selector **11** in FIG. **3** (**(a)** in FIG. **6**). Also, symbols P0(1), P0(2), ..., P0(n) of packet **P0** as the first corrected data **C1** are sequentially input into the selector **11** (**(b)** in FIG. **6**).

The selector **11** outputs the symbols of packet **P2** as the input data **DI** and the symbols of packet **P0** as the first corrected data **C1** to the syndrome operator **12** alternately, like P2(1), P0(1), P2(2), P0(2), ..., P0(n), for example. The syndrome operator **12** performs syndrome computation for the respective symbols received from the selector 11 sequentially in the order of receipt (**(c)** in FIG. **6**). The syndrome operator **12** outputs the input data syndromes **SI** of the input data **DI** for packet **P2** and the corrected data syndromes **SC** of the first corrected data **C1** for packet **P0** to the input data syndrome holder **13** and the corrected data syndrome holder **14,** respectively, once the n-th symbols have been computed. The syndrome operator **12** performs the operation of the symbols at a rate double the rate of input of the symbols of the input data **DI.**

In the second pipeline stage, the input data syndrome holder **13** outputs the input data syndromes **SI** for packet **P2** to the first zero syndrome detector **15** (**(d)** in FIG. **6**). The corrected data syndrome holder **14** outputs the corrected data syndromes **SC** for packet **P0** to the second zero syndrome detector **16** (**(f)** in FIG. **6**). In the second pipeline stage, also, the first zero syndrome detector **15** outputs the results of detection on whether or not all the input data syndromes **SI** for packet **P2** are zero as the first non-error state indication signal **F1.** For example, when all the input data syndromes **SI** are zero indicating that packet **P2** has no error, the first zero syndrome detector 15 asserts the first non-error state indication signal **F1** (**(e)** in FIG. **6**). Likewise, the second zero syndrome detector **16** outputs the results of detection on whether or not all the corrected data syndromes **SC** for packet **P0** are zero as the second non-error state indication signal **F2** (**(g)** in FIG. **6**).

In the third pipeline stage, as in the first pipeline stage, the syndrome operator **12** computes the input data syndromes **SI** for packet **P4** and the corrected data syndromes **SC** for packet **P2** (**(c)** in FIG. **6**).

In the fourth pipeline stage, the first zero syndrome detector **15** outputs the results of detection on whether or not all the input data syndromes **SI** for packet **P4** are zero as the first non-error state indication signal **F1** (**(e)** in FIG. **6**). The second zero syndrome detector **16** outputs the results of detection on whether or not all the corrected data syndromes **SC** for packet **P2** are zero as the second non-error state indication signal **F2** (**(g)** in FIG. **6**). In this way, the syndrome computation section **10** completes the processing for one packet in the four pipeline stages.

As described above, the decoding device of the present invention performs syndrome computation again for the error-corrected data **C1** obtained by error-correcting the input data **DI,** to obtain the corrected data syndromes **SC.** When the correction is considered improper, the input data before the correction is output. Thus, output of improperly corrected data can be avoided.

In the embodiment described above, error correction is performed once before the decision on whether or not the generated corrected data has an error. The decision may also be made after error correction is performed a plurality of times. In other words, the input data **DI** may be stored and error correction may be repeated until no error is detected in corrected data. If errorless corrected data is successfully generated, the corrected data may be output. If no errorless corrected data is generated after the repetition of error correction a plurality of times, failure of generation of errorless corrected data is decided, and the stored input data **DI** as the received word before the correction may be output. Note that, in this case, every time the error correction section **40** outputs corrected data, the syndrome computation section **10** must compute syndromes of the corrected data, decide whether or not the syndromes are zero, notify the error correction section **40** of the results, and output the syndromes to the evaluator/locator polynomial deriving section **20**.

The decoding device of the present invention may be implemented by software by use of microprocessors and the like.

### INDUSTRIAL APPLICABILITY

The present invention is useful for decoding of information encoded with an extended Reed-Solomon code.

## Claims

1. A decoding device comprising a correction processing section for performing error correction for a received word made of an extended Reed-Solomon code to determine corrected data,
wherein the correction processing section decides whether or not the generated corrected data has an error based on syndromes of the corrected data, and
the correction processing section outputs the corrected data when errorless corrected data is generated, while outputting the received word before the error correction when errorless corrected data fails to be generated.

2. The decoding device of Claim 1, wherein the correction processing section decides that errorless corrected data fails to be generated when the corrected data generated from the received word has an error.

3. The decoding device of Claim 1, wherein the correction processing section executes the error correction repeatedly until errorless corrected data is generated, and
decides that errorless corrected data fails to be generated when no errorless corrected data is generated after execution of the error correction a plurality of times.

4. A decoding device comprising:
a syndrome computation section for receiving a received word made of an extended Reed-Solomon code as input data, computing syndromes for the input data as input data syndromes, and outputting a first flag signal indicating whether or not the input data has an error that is determined based on the input data syndromes, while computing syndromes for first corrected data obtained based on the input data as corrected data syndromes and outputting a second flag signal indicating whether or not the first corrected data has an error that is determined based on the corrected data syndromes;
an evaluator/locator polynomial deriving section for computing coefficients at each order of an error evaluator polynomial and an error locator polynomial based on the input data syndromes, and computing error magnitudes based on error evaluation values and corresponding error locator polynomial differential values both obtained from the coefficients;
a Chien search section for determining roots of the error locator polynomial based on the coefficients, and computing the error evaluation values by substituting the roots in the error evaluator polynomial and the error locator polynomial differential values by substituting the roots in a derivative of the error locator polynomial; and
an error correction section for outputting data obtained by performing the error correction for the input data based on the roots and the corresponding error magnitudes as the first corrected data when the first flag signal indicates that the input data has an error, while outputting the input data as the first corrected data when the first flag signal indicates that the input data has no error,
the error correction section outputting data obtained by performing restoration for the first corrected data to restore the data before the error correction as second corrected data when the second flag signal indicates that the first corrected data has an error, while outputting the first corrected data as the second corrected data when the second flag signal indicates that the first corrected data has no error.

5. The decoding device of Claim 4, wherein the syndrome computation section comprises:
a selector for receiving the input data and the first corrected data output from the error correction section and outputting both the data alternately;
a syndrome operator for computing the input data syndromes and the corrected data syndromes based on the input data and the first corrected data output from the selector;
an input data syndrome holder for holding and outputting the input data syndromes;
a corrected data syndrome holder for holding and outputting the corrected data syndromes;
a first zero syndrome detector for outputting the first flag signal indicating that the input data has no error when all the input data syndromes output from the input data syndrome holder are zero and otherwise indicating that the input data has an error; and
a second zero syndrome detector for outputting the second flag signal indicating that the first corrected data has no error when all the corrected data syndromes output from the corrected data syndrome holder are zero and otherwise indicating that the first corrected data has an error.

6. The decoding device of Claim 4, wherein the evaluator/locator polynomial deriving section computes coefficients at each order of the error evaluator polynomial and the error locator polynomial based on the input data syndromes by Euclidean algorithm operation and outputs the computed coefficients, and
the evaluator/locator polynomial deriving section outputs the coefficients even when the order of the error locator polynomial is equal to or less than the order of the error evaluator polynomial at the completion of the Euclidean algorithm operation.

7. The decoding device of Claim 4, wherein the Chien research section sequentially substitutes elements of a Galois field in which roots of the extended Reed-Solomon code are defined in the error locator polynomial to determine elements of which substitution makes the value of the error locator polynomial zero as the roots of the error locator polynomial, and
the Chien research section outputs the roots of the error locator polynomial even when the number of different roots of the error locator polynomial is less than the order of the error locator polynomial.

8. The decoding device of Claim 4, wherein the error correction section comprises:
a first error corrector for outputting data obtained by performing the error correction for the input data when the first flag signal indicates that the input data has an error, the error correction including subtracting the corresponding error magnitude from a symbol indicated by the error location corresponding to each of the roots, while otherwise outputting the input data as the first corrected data;
an error location data holder for holding and outputting the error locations;
an error magnitude data holder for holding and outputting the error magnitudes; and
a second error corrector for outputting data obtained by performing the restoration for the first corrected data to restore the data before the error correction when the second flag signal indicates that the first corrected data has an error, the restoration including adding the corresponding error magnitude to a symbol indicated by the error location, while otherwise outputting the first corrected data as the second corrected data.

9. The decoding device of Claim 4, further comprising a data storage section for holding the input data until the error correction section starts determining the first corrected data and then outputting the input data, and holding the first corrected data until the error correction section starts determining the second corrected data and then outputting the first corrected data.

10. A decoding method comprising a correction processing step of performing error correction for a received word made of an extended Reed-Solomon code to determine corrected data,
wherein in the correction processing step, whether or not the generated corrected data has an error is decided based on syndromes of the corrected data, and
when errorless corrected data is generated, the generated corrected data is determined as the corrected data to be obtained, while when errorless corrected data fails to be generated, the received word before the error correction is determined as the corrected data to be obtained.

11. The decoding method of Claim 10, wherein in the correction processing step, failure of generation of errorless corrected data is decided when the corrected data generated from the received word has an error.

12. The decoding method of Claim 10, wherein in the correction processing step, the error correction is executed repeatedly until errorless corrected data is generated, and
failure of generation of errorless corrected data is decided when no errorless corrected data is generated after execution of the error correction a plurality of times.
